(19) Europäisches Patentamt
European Patent Office
Office européen des brevets

(11) **EP 1 793 235 A1**

(12) **EUROPÄISCHE PATENTANMELDUNG**

(43) Veröffentlichungstag:
**06.06.2007 Patentblatt 2007/23**

(51) Int Cl.:
*G01R 31/327* *(2006.01)*

(21) Anmeldenummer: 05405679.1

(22) Anmeldetag: **30.11.2005**

(84) Benannte Vertragsstaaten:
**AT BE BG CH CY CZ DE DK EE ES FI FR GB GR HU IE IS IT LI LT LU LV MC NL PL PT RO SE SI SK TR**
Benannte Erstreckungsstaaten:
**AL BA HR MK YU**

(71) Anmelder: **ABB Technology AG**
**8050 Zürich (CH)**

(72) Erfinder:
• **Hagel, Marek**
  **8956 Killwangen (CH)**
• **Fehlmann, Patrick**
  **5210 Windisch (CH)**

(74) Vertreter: **ABB Patent Attorneys**
**c/o ABB Schweiz AG,**
**Intellectual Property (CH-LC/IP),**
**Brown Boveri Strasse 6**
**5400 Baden (CH)**

(54) **Überwachungssystem für Hochspannungsschalter**

(57) Die Erfindung betrifft ein Verfahren und eine Vorrichtung zur Messung des Kontaktabbrands in einem elektrischen Schaltgerät (1) mittels einer neuartigen dynamischen Widerstandsmessung (DRM). Erfindungsgemäss wird zur Bestimmung einer Überlappungszeit ($\Delta T$) und eines Kontaktabbrands im Schaltgerät (1) eine Stromänderung $\Delta I_2$ über das Schaltgerät (1) indirekt gemessen, indem ein Messstrom ($I_0$) über das Schaltgerät (1) und einen Parallelleiter (12) geführt wird und die Stromänderung ($\Delta I_2$) im Parallelleiter (12) gemessen wird. Ausführungsbeispiele betreffen u. a.: Erfassung eines differentiellen Strommesssignals ($\Delta I_1(t)$, $dI_1(t)/dt$) im Parallelleiter (12) mit Hilfe einer Rogowski Spule (8a); und Wahl eines Parallelleiterwiderstands ($R_1$) in der Grössenordnung des Schalterwiderstands ($R_2$). Vorteile sind u. a.: kleine Änderungen ($\Delta R_2$) des Schalterwiderstands ($R_2$) im Bereich $\mu\Omega$ bewirken grosse Stromänderungen im Bereich einiger 100 mA schon bei geringem Messstrom $I_0$ von wenigen A. Dadurch kann ein handliches, transportables DRM-Messgerät geschaffen werden.

Fig. 2

**Beschreibung**

**TECHNISCHES GEBIET**

Die Erfindung bezieht sich auf das Gebiet der Hochspannungstechnik, insbesondere der Leistungsschalter in elektrischen Energieverteilnetzen. Sie geht aus von einem Verfahren und einer Vorrichtung zur Überwachung eines Schaltgeräts gemäss Oberbegriff der unabhängigen Patentansprüche.

**STAND DER TECHNIK**

Die Dynamische Widerstandsmessung (DRM) wird zur Bestimmung der Überlappungszeit eines Leistungsschalters verwendet. Die Überlappungszeit ist die zeitliche Differenz zwischen der Kontakttrennung im Nennstromkontaktsystem und der Kontakttrennung im Abbrand- oder Lichtbogenkontaktsystem und zeigt an, wie stark die Lichtbogenkontakte bereits abgebrannt sind. Damit kann eine Aussage über die verbleibende Lebensdauer einer Löschkammer gemacht werden. Bei DRM wird während einer CO-Operation (Schalter schliessen, dann öffnen) ein konstanter Gleichstrom in der Grössenordnung von 1kA über den Schalter übertragen und der Spannungsabfall über dem Schalter aufgezeichnet. Die Aufzeichnung der Spannung erlaubt die Bestimmung des Leitungswiderstandes des Schalters zu jedem Zeitpunkt. Damit können die beiden Zeitpunkte, an denen die Kontaktsysteme öffnen, und somit auch die Überlappungszeit, festgestellt werden. Dass der übertragene Gleichstrom so gross sein muss, liegt daran, dass die Widerstände beider Kontaktsysteme sehr klein sind und sich nur geringfügig unterscheiden. Nur bei Übertragung eines sehr grossen Stroms befindet sich die Spannungsdifferenz zwischen Abbrand- und Nennstromkontaktsystem im messbaren Bereich.
Ein Nachteil dieser Methode ist die Grösse der benötigten Apparatur, welche jeweils zur entsprechenden Anlage transportiert werden muss. Neben den Transportkosten für die Serviceleute entstehen zusätzlich Transportkosten für das Testgerät. Um diese einzusparen, besteht Interesse an einem kleineren Messgerät, welches die Überlappungszeit mit gleicher Zuverlässigkeit misst wie das bisherige, vom Servicepersonal aber als Handgepäck transportiert werden kann.

**DARSTELLUNG DER ERFINDUNG**

Aufgabe der vorliegenden Erfindung ist es, ein Verfahren und eine Vorrichtung zur verbesserten Überwachung des Kontaktabbrands in einem elektrischen Schaltgerät anzugeben. Diese Aufgabe wird erfindungsgemäss durch die Merkmale der unabhängigen Ansprüche gelöst.
Gegenstand der Erfindung ist ein Verfahren zur Messung des Kontaktabbrands in einem elektrischen Schaltgerät, das einen Nennstrompfad mit einem Nennstromkontaktsystem und einen Abbrandkontaktstrompfad mit einem Abbrandkontaktsystem aufweist, wobei aus einer Widerstandsänderung bei Trennung der Nennstromkontakte und der Abbrandkontakte eine Überlappungszeit zwischen der Trennung der Nennstromkontakte und der Abbrandkontakte gemessen wird und daraus ein Abbrand der Abbrandkontakte bestimmt wird, wobei ferner von einem Einspeisestrom aus einer Messstromquelle ein erster Strom und ein zweiter Strom abgezweigt wird, der erste Strom durch das Schaltgerät und der zweite Strom parallel zum Schaltgerät geführt wird und der zweite Strom mit Hilfe eines Messsystems erfasst wird und aus einer Änderung des zweiten Stroms als Funktion der Zeit die Überlappungszeit bestimmt wird.
In einem weiteren Aspekt besteht die Erfindung in einem Messsystem zur Messung des Kontaktabbrands in einem elektrischen Schaltgerät, das einen Nennstrompfad mit einem Nennstromkontaktsystem und einen Abbrandkontaktstrompfad mit einem Abbrandkontaktsystem aufweist, wobei das Messsystem eine Messstromquelle, einen Sensor und eine Auswerteeinheit umfasst, die zur zeitabhängigen Widerstandsmessung über das Schaltgerät, d.h. zur Widerstandsmessung über das Schaltgerät als Funktion der Zeit, zur Bestimmung einer Überlappungszeit zwischen der Trennung der Nennstromkontakte und der Abbrandkontakte und daraus zur Bestimmung eines Abbrands der Abbrandkontakte dienen, wobei ferner ein Parallelleiter parallel zum Schaltgerät vorhanden ist und der Sensor am Parallelleiter angeordnet ist, die Messstromquelle mit dem Schaltgerät zur Einspeisung eines ersten Stroms und mit dem Parallelleiter zur Einspeisung eines zweiten Stroms verbunden ist und der Sensor zur Erfassung des zweiten Stroms dient und die Auswerteeinheit Mittel zur Bestimmung der Überlappungszeit aus einer Änderung des zweiten Stroms als Funktion der Zeit aufweist. Die Stromerfassung im Parallelleiter kann auf vielfältige Weise erfolgen, insbesondere durch einen induktiv oder anderweitig angekoppelten Sensor. Durch die Verwendung eines parallelen Messstrompfades kann auf indirekte Weise die Widerstandsänderung am Schalter auch bei geringem Einspeisemessstrom mit hoher Präzision gemessen werden.
In einem bevorzugten Ausführungsbeispiel ist der Stromsensor eine Rogowski Spule, die ein differentielles Strommesssignal proportional zur ersten Zeitableitung des zweiten Stroms misst. Die Rogowski Spule besitzt durch ihr differentielles Verhalten eine hohe Messempfindlichkeit für Änderungen des zweiten Stroms und indirekt des ersten Stroms. Insbesondere kann das differentielle Strommesssignal zur Bestimmung der Überlappungszeit ohne vorherige Integration und/oder nach einer Integration über die Zeit ausgewertet werden.

Weitere Ausführungen, Vorteile und Anwendungen der Erfindung ergeben sich aus abhängigen Ansprüchen, aus Anspruchskombinationen sowie aus der nun folgenden Beschreibung und den Figuren.

## KURZE BESCHREIBUNG DER ZEICHNUNGEN

Es zeigen schematisch

Fig. 1    ein vereinfachtes elektrisches Schaltschema eines Schaltgeräts mit zwei Kontaktsystemen;

Fig. 2    eine Ausführungsform eines Messsystems mit erfindungsgemässem Paralleleiter zur Überwachung von Kontaktabbrand in einem Schaltgerät;

Fig. 3    ein Diagramm mit Strom- bzw. Spannungsmesskurven und einer Weg-Zeitkurve zur dynamischen Widerstandsmessung; und

Fig. 4    ein Diagramm zur Optimierung des Paralleleiterwiderstands.

In den Figuren werden für gleiche Teile die gleichen Bezugszeichen verwendet.

## WEGE ZUR AUSFÜHRUNG DER ERFINDUNG

Leistungsschalter 1, beispielsweise Hochspannungsleistungsschalter, Hochstromleistungsschalter (Generatorschalter) oder Lasttrennschalter, haben grundsätzlich zwei Kontaktsysteme, nämlich ein Nennstromkontaktsystem 3 und ein Lichtbogen- oder Abbrandkontaktsystem 5. Das Nennstromkontaktsystem 3 hat die Aufgabe, den Strom bei geschlossenem Schalter 1 so verlustfrei wie möglich zu übertragen. Es zeichnet sich daher durch einen sehr kleinen Leitungs- und Kontaktübergangswiderstand aus. Das Abbrandkontaktsystem 5 führt nur während der kurzen Zeit zwischen Öffnung der Nennstromkontakte 3 und seiner eigenen Öffnung einen nennenswerten Strom. Dem Widerstand des Abbrandkontaktsystems 5 kommt somit eine weniger bedeutende Rolle zu, und dieser Widerstand ist deshalb bei sämtlichen Leistungsschaltern 1 um einiges grösser als der Widerstand des Nennstromkontaktsystems 3.

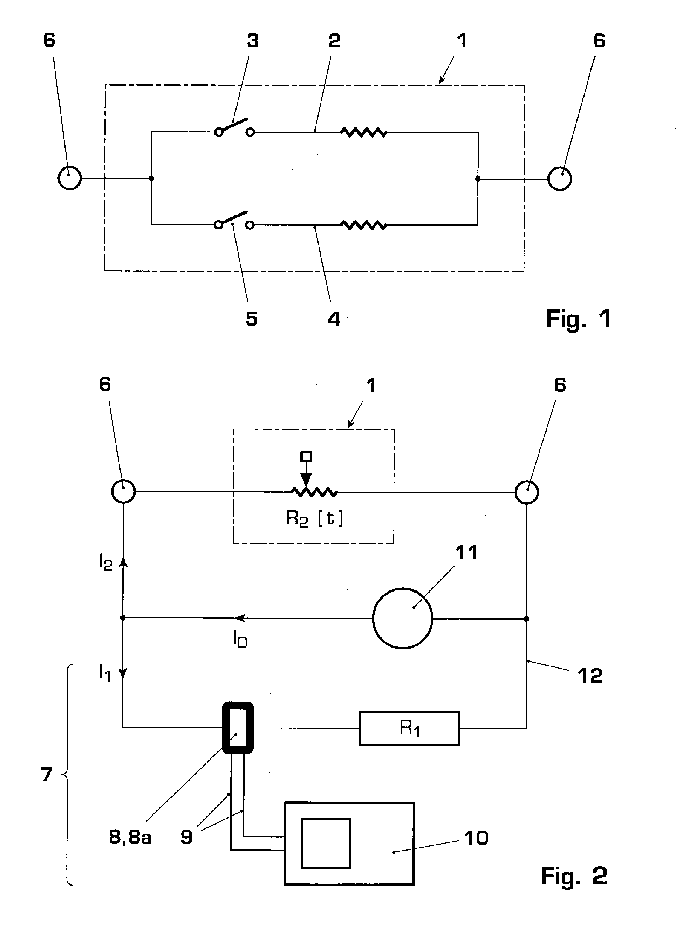

Fig. 1 zeigt eine schematische Darstellung eines solchen Leistungsschalters 1. Bei einem Ausschaltvorgang (Open) wird zuerst das Nennstromkontaktsystem 3 geöffnet. Der Strom kommutiert vom Nennstrompfad 2 auf den Abbrandkontaktstrompfad 4 mit den Abbrandkontaktsystem 5, das nach einigen Millisekunden Überlappungszeit bzw. Kommutierungszeit ebenfalls öffnet.

Bei der dynamischen Widerstandsmessung (DRM) macht man sich zur Bestimmung der Überlappungszeit die Tatsache zu Nutzen, dass sich die Widerstände der beiden Kontaktsysteme unterscheiden. In einem Generatorschalter können beispielsweise die Widerstände 2 $\mu\Omega$ - 20 $\mu\Omega$ für die Nennstromkontakte 3 und 300 $\mu\Omega$ - 800 $\mu\Omega$ für die Abbrandkontakte 5 betragen. Nachteilig an der konventionellen DRM ist, dass ein ausserordentlich grosser konstanter Gleichstrom in der Grössenordnung von 1kA über den geschlossenen Schalter 1 übertragen werden muss, um die Spannungsdifferenz zwischen Abbrand- und Nennstromkontaktsystem mit hinreichender Genauigkeit messen zu können.

Fig. 2 zeigt ein Ausführungsbeispiel der dynamischen Widerstandsmessung gemäss der Erfindung, DRM-Light genannt. DRM-Light unterscheidet sich grundsätzlich von der konventionellen DRM-Methode. Die Widerstandsänderung im Schalter 1 wird mit Hilfe eines parallel montierten Leiters 12 gemessen, der je nach Zustand des Schalters 1 mehr oder weniger Strom führt. Dabei ist über dem Schaltgerät 1 ein dynamisch, d. h. zeitabhängig zu messender Schalterwiderstand $R_2$ (t) und über den Paralleleiter 12 zum Schaltgerät 1 ein Parallelleiterwiderstand $R_1$ vorhanden. Im Parallelwiderstand $R_1$ ist mit Vorteil der Anschlusswiderstand an Kontaktklemmen mitenthalten.

Im einzelnen zeigt Fig. 2 das Schaltgerät 1, mit dessen Anschlüssen oder Messterminals 6 das Messsystem 7 elektrisch verbunden ist. Das Messsystem 7 umfasst eine Messstromquelle 11, einen Sensor 8, 8a und eine Auswerteeinheit 10, die zur zeitabhängigen Widerstandsmessung über das Schaltgerät 1, zur Bestimmung einer Überlappungszeit zwischen der Trennung der Nennstromkontakte 3 und der Abbrandkontakte 5 und daraus zur Bestimmung eines Abbrands der Abbrandkontakte 5 dienen. Erfindungsgemäss ist der Sensor 8, 8a am Parallelleiter 12 angeordnet, ist die Messstromquelle 11 mit dem Schaltgerät 1 zur Einspeisung eines ersten Stroms $I_2$ und mit dem Parallelleiter 12 zur Einspeisung eines zweiten Stroms $I_1$ verbunden und erfasst der Sensor 8, 8a den zweiten Strom $I_1$, wobei die Auswerteeinheit 10 Mittel zur Bestimmung der Überlappungszeit $\Delta T$ aus einer Änderung des zweiten Stroms $I_1$ als Funktion der Zeit t aufweist. Im folgenden werden hierzu Ausführungsbeispiele angegeben.

Mit Vorteil und wie in Fig. 2 dargestellt ist der gesamte Einspeisestrom $I_0$ gleich der Summe des ersten und zweiten Stroms $I_1+I_2$; und/oder ist die Messstromquelle 11 eine Kontantgleichstromquelle 11, beispielsweise ein Akkumulator mit einem vorgeschalteten, vorzugsweise grossen Widerstand. Der Akkumulator liefert einen konstanten Gleichstrom $I_0$ in der Grössenordnung weniger Ampere. Dies genügt im Zusammenwirken mit dem erfindungsgemässen Parallelleiter 12 als Strommesszweig, um Überlappungszeit und Kontaktabbrand des Schalters 1 sehr genau zu messen.

Vorteilhafterweise umfasst das Messsystem 7 auch Mittel zur Erfassung der Kontaktbewegung s(t). Auch kann das Messsystem 7 als tragbares Gerät konzipiert sein. Das zu untersuchende Schaltgerät 1 kann beispielsweise ein Leistungsschalter 1, ein Hochstrom- oder Generatorschalter 1 oder ein Lasttrennschalter 1 sein.

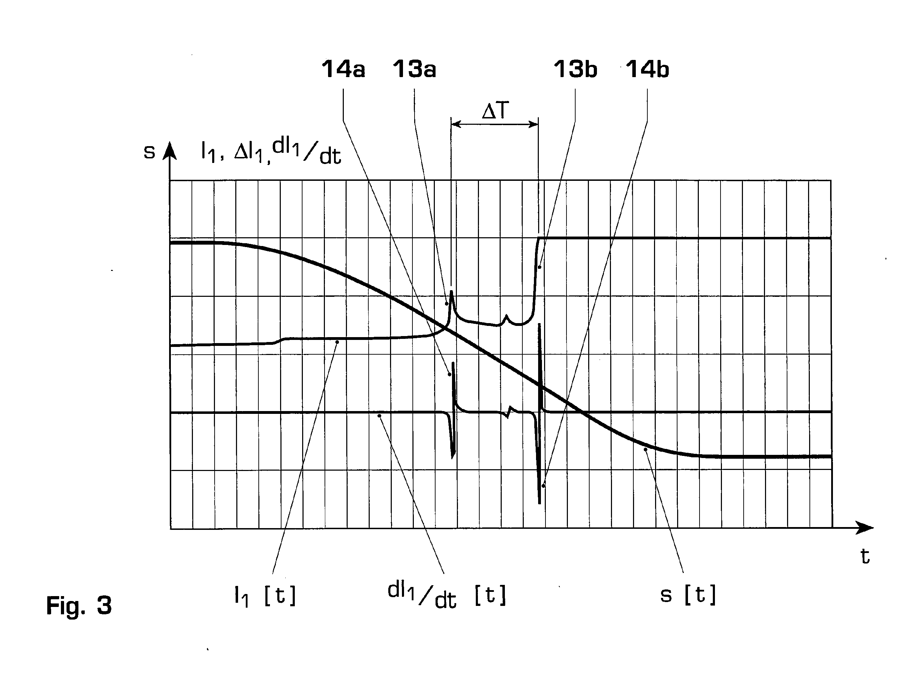

Gemäss Fig. 2 und Fig. 3 dient der Sensor 8, 8a dazu, ein Strommesssignal, z. B. $I_1(t)$ oder $\Delta I_1(t)$ oder $dI_1(t)/dt$ oder eine andere Zeitableitung des zweiten Stroms $I_1$ oder Kombinationen solcher Stromgrössen, als Funktion der Zeit t zu erfassen, wobei das Strommesssignal den zweiten Strom $I_1$ durch den Parallelleiter 12 und dadurch indirekt den ersten Strom $I_2$ über den Schalter 1 charakterisiert. Typischerweise ist der Sensor 8, 8a ein Stromsensor, der beispielsweise induktiv ein differentielles Strommesssignal $\Delta I_1(t)$ oder $dI_1(t)/dt$ proportional zu einer Zeitableitung des zweiten Stroms $I_1$ misst. Bevorzugt ist der Stromsensor 8a eine Rogowski Spule 8a, die ein differentielles Strommesssignal $\Delta I_1(t)$ oder $dI_1(t)/dt$ proportional zur ersten Zeitableitung des zweiten Stroms $I_1$ misst.

Für die Rogowsky-Spule 8a oder allgemein einen magnetischen Strommesser kann man das Ausgangssignal beschreiben durch $u(t)=M*dI_1(t)/dt$, wobei $u(t)$ eine in der Messspule induzierte Spannung ist, welche als Ausgangssignal zur Verfügung steht, sowie der Proportionalitätsfaktor M eine Gegeninduktivität bezeichnet, die zwischen der Messspule und dem Strompfad besteht.

Darüberhinaus soll die Auswerteeinheit 10 Mittel zur Erfassung einer ersten und zweiten Signatur 13a, 13b; 14a, 14b im Strommesssignal, z. B. $I_1(t)$ oder $\Delta I_1(t)$ oder $dI_1(t)/dt$, aufweisen, wobei die Signaturen 13a, 13b; 14a, 14b durch die Widerstandsänderungen bei Trennung der Nennstromkontakte 3 und der Abbrandkontakte 5 verursacht sind. Desweiteren soll die Auswerteeinheit 10 Mittel zur Bestimmung der Überlappungszeit $\Delta T$ aus der Differenz der Zeitpunkte der ersten und zweiten Signatur 13a, 13b; 14a, 14b aufweisen.

Dies soll anhand von Fig. 3 näher erläutert werden. Fig. 3 zeigt über einer gemeinsamen Zeitachse t eine Wegkurve s(t) der Kontaktbewegung im Schalter 1, die auf diverse, an sich bekannte Weisen aufgezeichnet werden kann (z. B. mittels Linearpotentiometer am Antrieb), sowie ein direktes Strommesssignal $I_1(t)$ und ein differentielles Strommesssignal $\Delta I_1(t)$ oder $dI_1(t)/dt$, das proportional zu einer ersten Ableitung des direkten Strommesssignals $I_1(t)$ ist. Ein solches differentielles Strommesssignal kann durch einen induktiv Ankopplung an den zweiten Strom $I_1$ gewonnen werden.

Bei vollständig geschlossenem Schalter 1 teilt sich der Einspeisestrom $I_0$ auf Nennstromkontaktsystem 3, Abbrandkontaktsystem 5 und Parallelleiter 12 auf. Bei Öffnung des Nennstromkontaktsystems 3 vergrössert sich der Widerstand $R_2(t)$ im Schalter 1, wodurch auch der Strom $I_1$ im Parallelleiter 12 vergrössert wird. Nach vollständiger Öffnung des Schalters 1 fliesst der ganze Strom $I_0=I_1$ durch den Parallelleiter 12. Die Stromänderungen $\Delta I_1(t)$ oder zeitliche Ableitung $dI_1(t)/dt$ im Parallelleiter 12 werden oder wird mit Hilfe einer Rogowskispule 8a detektiert. Aus dem Rogowskispulensignal $\Delta I_1(t)$ oder $dI_1(t)/dt$ kann durch zeitliche Integration, z. B. messtechnisch oder durch Berechnung, das direkte Strommessignal $I_1(t)$ bestimmt werden.

Es ist zu erkennen, dass die gesuchte Überlappungs- oder Kommutierungszeit $\Delta T$ durch das Messen der Zeit zwischen den von der Rogowski Spule 8a erzeugten Peaks ermittelt werden kann. Ein Integrieren des Spulensignals ist nicht notwendig, kann aber Fehlinterpretationen vorbeugen. Daher kann durch Auswertung der Zeitpunkte aus dem direkten Strommessignal $I_1(t)$ und dem oder einem differentiellen Strommessignal $\Delta I_1(t)$ oder $dI_1(t)/dt$ oder gegebenenfalls einer höheren Zeitableitung die Zuverlässigkeit der dynamischen Widerstandsmessmethode und Widerstandsmessapparatur 7 weiter verbessert werden.

Die Messkurven s(t), $\Delta I_1(t)$ oder $dI_1(t)/dt$ und $I_1(t)$ in Fig. 3 wurden experimentell an Generatorschaltern 1 aufgenommen und erlauben eine zuverlässige Bestimmung der Überlappungszeit $\Delta T$, des Kontaktabbrands und der erforderlichen Unterhaltsarbeiten und Revisionszeitpunkte für den Schalter 1.

In den Strommessignalen $I_1(t)$ oder $\Delta I_1(t)$ oder $dI_1(t)/dt$ tritt also eine erste Signatur 13a, 14a auf, welche einen ersten Zeitpunkt der Nennstromkontakttrennung charakterisiert, und eine zweite Signatur 13b, 14b, welche einen zweiten Zeitpunkt der Abbrandkontakttrennung charakterisiert. Im angegebenen Beispiel sind die Signaturen 13a, 13b im direkten Strommesssignal $I_1(t)$ Peaks und die Signaturen 14a, 14b im differentiellen Strommesssignal $\Delta I_1(t)$ oder $dI_1(t)/dt$ die erste zeitliche Ableitung der Peaks. Je nach Sensor 8, 8a und Messeinrichtung 10 sind auch andere Signaturen möglich und hinsichtlich der Zeitpunkte ihres Auftretens auswertbar.

Im Ausführungsbeispiel gemäss Fig. 3 ist die Widerstandsänderung $\Delta R_2$ im Schalter 1 beim ersten Übergang 13a, 14a vom Nennstromkontaktsystem 3 zum Abbrandkontaktsystem 5 sehr gering. Typischerweise liegt $\Delta R_2$ im Bereich von $\mu\Omega$. Um diesen ersten Übergang 13a, 14a zuverlässig bestimmen zu können, sollte bei gegebener Widerstandsänderung $\Delta R_2$ eine möglichst grosse Stromänderung $\Delta I_1$ erreicht werden. Zugleich soll der einzuspeisende Strom $I_0$ klein gehalten werden. In der Erfindung werden Werte von $\Delta I_1$ in der Grössenordnung von einigen Hundert mA und von $I_0$ von einigen A erreicht. Für diesen Zweck soll auch der Widerstand $R_1$ des Parallelleiters 12 optimiert werden, und es stellt sich die Frage, inwiefern die Resultate vom Widerstand $R_1$ des Parallelleiters 12 abhängen.

Gemäss einem Ausführungsbeispiel kann der Parallelleiterwiderstand $R_1$ optimal gewählt werden. Es gilt

$$I_1(t) = I_0 \frac{R_2(t)}{R_1 + R_2(t)} \quad,$$

[1]

wobei $I_0$ der Strom der Stromquelle, $R_1$ der Widerstand des Parallelleiters und $R_2(t)$ der zeitlich veränderliche Widerstand des Schalters ist. Bei der Änderung des Widerstands $R_2(t)$ um $\Delta R_2$ ändert sich der Strom $I_1(t)$ zum Zeitpunkt $t_1$ um $\Delta I_1$, näherungsweise gegeben durch

$$\Delta I_1 = \left. \frac{\partial I_1}{\partial R_2} \right|_{R_2 = R_2(t_1)} \Delta R_2$$

[2]

und es gilt

$$\Delta I_1 = I_0 * \Delta R_2 * k(R_1)$$

[3]

$$k(R_1) = R_1 * (R_1 + R_2)^{-2}$$

[4]

wobei $R_2$ zum Zeitpunkt $t_1$ den Wert des Widerstandes des Abbrandkontaktsystems 5 des Schalters 1 und $k(R_1)$ eine Proportionalitätskonstante oder einen Empfindlichkeitskoeffizienten als Funktion des Parallelleiterwiderstands $R_1$ darstellt.

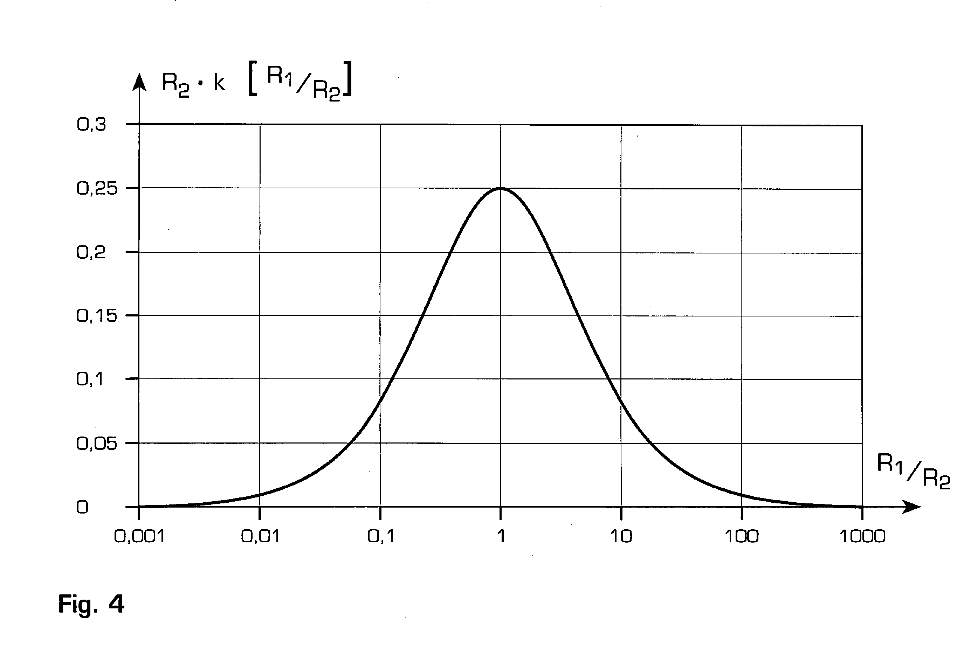

In Fig. 4 ist die Empfindlichkeitsfunktion $R_2*k$ als Funktion von $R_1/R_2$ gezeigt. Sie besitzt ein Maximum $k_{max}=0,25$ [$1/\Omega$] für $R_2=R_1$ und fällt für $R_2>R_1$ (ebenso für $R_2<R_1$) ab. Gemäss einem bevorzugten Ausführungsbeispiel soll ein Verhältnis des Parallelleiterwiderstands $R_1$ zum Schalterwiderstand $R_2$ kleiner als 100, bevorzugt kleiner als 30, besonders bevorzugt kleiner als 10, insbesondere kleiner als 5, gewählt werden. Vorzugsweise soll in absoluten Grössen der Parallelleiterwiderstand $R_1$ kleiner als 10 m$\Omega$, bevorzugt kleiner als 2 m$\Omega$, besonders bevorzugt kleiner als 1 m$\Omega$, insbesondere gleich einem Maximum des Schalterwiderstands $R_2$ gewählt werden.

Gegenstand der Erfindung ist auch ein Messverfahren gemäß unabhängigem Anspruch 1 und mit den Ausführungsbeispielen gemäß den abhängigen Ansprüchen 2-7.

**BEZUGSZEICHENLISTE**

| 1 | elektrisches Schaltgerät, Unterbrechereinheit; Hochspannungsleistungsschalter, Hochstromleistungsschalter |
|---|---|
| 2 | Nennstrompfad |
| 3 | Nennstromkontaktsystem |
| 4 | Abbrandkontaktstrompfad |
| 5 | Abbrandkontaktsystem |
| 6 | Anschlüsse für Messsystem |
| 7 | Messsystem |
| 8 | Detektionseinheit, Sensor, Stromsensor |
| 8a | Rogowski-Spule |
| 9 | Signalleitungen |
| 10 | Auswerteeinheit, Messelektronik |
| 11 | Messstromquelle, Gleichstromquelle |
| 12 | Parallelleiter, Parallelstrompfad |

13a, 13b    erste Signatur, erster Peak im Strommesssignal
14a, 14b    zweite Signatur, zweiter Peak im Strommesssignal

$I_0$    Einspeisestrom
$I_1$    erster Strom, Messstrom durch Parallelleiter
$I_2$    zweiter Strom, Strom durch Schaltgerät, Schalterstrom
$I_1(t)$, $I_2(t)$    zeitlich veränderlicher Strom
$dI_1(t)/dt$    Zeitableitung des ersten Stroms
$\Delta I_1$, $\Delta I_2$    Stromänderungen
$I_1(t)$, $\Delta I_1(t)$, $dI(t)/dt$    Strommesssignal durch Parallelleiter
k    Konstante, Empfindlichkeitsfunktion
$R_1$    Widerstand des Parallelleiters, Parallelleiterwiderstand
$R_2(t)$    Widerstand des Schaltgeräts, Widerstand des Abbrandkontaktsystems, Schalterwiderstand
$\Delta R_2$    Widerstandsänderung des Schaltgeräts, Widerstandsänderung des Abbrandkontaktsystems
t    Zeitkoordinate
$\Delta T$    Überlappungszeit
s(t)    Weg-Zeitkurve des Antriebs bzw. der Kontakte

## Patentansprüche

1. Verfahren zur Messung des Kontaktabbrands in einem elektrischen Schaltgerät (1), das einen Nennstrompfad (2) mit einem Nennstromkontaktsystem (3) und einen Abbrandkontaktstrompfad (4) mit einem Abbrandkontaktsystem (5) aufweist, wobei aus einer Widerstandsänderung bei Trennung der Nennstromkontakte (3) und der Abbrandkontakte (5) eine Überlappungszeit ($\Delta T$) zwischen der Trennung der Nennstromkontakte (3) und der Abbrandkontakte (5) gemessen wird und daraus ein Abbrand der Abbrandkontakte (5) bestimmt wird, **dadurch gekennzeichnet, dass**

   a) von einem Einspeisestrom ($I_0$) aus einer Messstromquelle (11) ein erster Strom ($I_1$) und ein zweiter Strom ($I_2$) abgezweigt wird,
   b) der erste Strom ($I_1$) durch das Schaltgerät (1) und der zweite Strom ($I_2$) parallel zum Schaltgerät (1) geführt wird und
   c) der zweite Strom ($I_1$) mit Hilfe eines Messsystems (7) erfasst wird und aus einer Änderung des zweiten Stroms ($I_1$) als Funktion der Zeit (t) die Überlappungszeit ($\Delta T$) bestimmt wird.

2. Verfahren zur Messung des Kontaktabbrands nach einem der vorangehenden Ansprüche, **dadurch gekennzeichnet, dass** mit Hilfe eines Stromsensors (8, 8a) ein den zweiten Strom ($I_1$) charakterisierendes Strommesssignal ($I_1(t)$, $\Delta I_1(t)$, $dI_1(t)/dt$) als Funktion der Zeit (t) erfasst wird.

3. Verfahren zur Messung des Kontaktabbrands nach Anspruch 2, **dadurch gekennzeichnet, dass**

   a) durch die Widerstandsänderungen bei Trennung der Nennstromkontakte (3) eine erste Signatur (13a, 14a) und bei Trennung der Abbrandkontakte (5) eine zweite Signatur (13b, 14b) im Strommesssignal ($I_1(t)$, $\Delta I_1(t)$, $dI_1(t)/dt$) gemessen wird und
   b) die Überlappungszeit ($\Delta T$) aus der Differenz der Zeitpunkte der ersten und zweiten Signatur (13a, 14a; 13b, 14b) bestimmt wird.

4. Verfahren zur Messung des Kontaktabbrands nach einem der vorangehenden Ansprüche, **dadurch gekennzeichnet, dass**

   a) vom Messsystem (7) ein differentielles Strommesssignal ($\Delta I_1(t)$, $dI_1(t)/dt$) proportional zur einer Zeitableitung des zweiten Stroms ($I_1$) gemessen wird,
   b) insbesondere dass mit einer Rogowski Spule (8a) ein differentielles Strommesssignal ($\Delta I_1(t)$, $dI_1(t)/dt$) proportional zur ersten Zeitableitung des zweiten Stroms ($I_1$) gemessen wird.

5. Verfahren zur Messung des Kontaktabbrands nach Anspruch 4, **dadurch gekennzeichnet, dass**

   a) das differentielle Strommesssignal ($\Delta I_1(t)$, $dI_1(t)/dt$) ohne vorherige Integration zur Bestimmung der Überlappungszeit ($\Delta T$) ausgewertet wird und/oder

b) das differentielle Strommesssignal ($\Delta I_1(t)$, $dI_1(t)/dt$) integriert wird und dann zur Bestimmung der Überlappungszeit ($\Delta T$) ausgewertet wird.

6. Verfahren zur Messung des Kontaktabbrands nach einem der vorangehenden Ansprüche, **dadurch gekennzeichnet, dass**

   a) der gesamte Einspeisestrom ($I_0$) auf den ersten Strom ($I_1$) und den zweiten Strom ($I_2$) aufgeteilt wird und/oder
   b) von der Messstromquelle (11) ein konstanter Gleichstrom ($I_0$) in der Grössenordnung weniger Ampere eingespeist wird.

7. Verfahren zur Messung des Kontaktabbrands nach einem der vorangehenden Ansprüche, **dadurch gekennzeichnet, dass** während einer Messphase vor Trennung der Abbrandkontakte (5)

   a) der erste Strom ($I_2$) einem Schalterwiderstand ($R_2$) über das Schaltgerät (1) und der zweite Strom ($I_1$) einem Paralleleiterwiderstand ($R_1$) durch den Paralleleiter (12) zum Schaltgerät (1) ausgesetzt wird und
   b) ein Verhältnis des Parallelleiterwiderstands ($R_1$) zum Schalterwiderstand ($R_2$) kleiner als 100, bevorzugt kleiner als 30, besonders bevorzugt kleiner als 10, insbesondere kleiner als 5, gewählt wird und
   c) insbesondere dass der Paralleleiterwiderstand ($R_1$) kleiner als 10 m$\Omega$, bevorzugt kleiner als 2 m$\Omega$, besonders bevorzugt kleiner als 1 m$\Omega$, insbesondere gleich einem Maximum des Schalterwiderstands ($R_2$), gewählt wird.

8. Messsystem (7) zur Messung des Kontaktabbrands in einem elektrischen Schaltgerät (1), das einen Nennstrompfad (2) mit einem Nennstromkontaktsystem (3) und einen Abbrandkontaktstrompfad (4) mit einem Abbrandkontaktsystem (5) aufweist, wobei das Messsystem (7) eine Messstromquelle (11), einen Sensor (8, 8a) und eine Auswerteeinheit (10) umfasst, die zur Widerstandsmessung über das Schaltgerät (1) als Funktion der Zeit (t), zur Bestimmung einer Überlappungszeit ($\Delta T$) zwischen der Trennung der Nennstromkontakte (3) und der Abbrandkontakte (5) und daraus zur Bestimmung eines Abbrands der Abbrandkontakte (5) dienen, **dadurch gekennzeichnet, dass**

   a) ein Parallelleiter (12) parallel zum Schaltgerät

      (1) vorhanden ist und der Sensor (8, 8a) am Parallelleiter (12) angeordnet ist,

   b) die Messstromquelle (11) mit dem Schaltgerät (1) zur Einspeisung eines ersten Stroms ($I_2$) und mit dem Parallelleiter (12) zur Einspeisung eines zweiten Stroms ($I_1$) verbunden ist und
   c) der Sensor (8, 8a) zur Erfassung des zweiten Stroms ($I_1$) dient und die Auswerteeinheit (10) Mittel zur Bestimmung der Überlappungszeit ($\Delta T$) aus einer Änderung des zweiten Stroms ($I_1$) als Funktion der Zeit (t) aufweist.

9. Messsystem (7) nach Anspruch 8, **dadurch gekennzeichnet, dass**

   a) der Sensor (8, 8a) ein den zweiten Strom ($I_1$) charakterisierendes Strommesssignal ($I_1(t)$, $\Delta I_1(t)$, $dI_1(t)/dt$) als Funktion der Zeit (t) erfasst und insbesondere ein Stromsensor (8, 8a) ist und
   b) insbesondere dass der Stromsensor (8, 8a) ein differentielles Strommesssignal ($\Delta I_1(t)$, $dI_1(t)/dt$) proportional zu einer Zeitableitung des zweiten Stroms ($I_1$) misst.

10. Messsystem (7) nach Anspruch 9, **dadurch gekennzeichnet, dass**

   a) der Stromsensor (8a) eine Rogowski Spule (8a) ist und ein differentielles Strommesssignal ($\Delta I_1(t)$, $dI_1(t)/dt$) proportional zur ersten Zeitableitung des zweiten Stroms ($I_1$) misst und
   b) zur Bestimmung der Überlappungszeit ($\Delta T$) das differentielle Strommesssignal ($\Delta I_1(t)$, $dI_1(t)/dt$) ohne vorherige Integration und/oder nach einer Integration über die Zeit (t) ausgewertet wird.

11. Messsystem (7) nach einem der Ansprüche 9-10, **dadurch gekennzeichnet, dass**

   a) die Auswerteeinheit (10) Mittel zur Erfassung einer ersten und zweiten Signatur (13a, 14a; 13b, 14b) im Strommesssignal ($I_1(t)$, $\Delta I_1(t)$, $dI_1(t)/dt$) aufweist, die durch die Widerstandsänderungen bei Trennung der Nennstromkontakte (3) und der Abbrandkontakte (5) auftreten und
   b) die Auswerteeinheit (10) Mittel zur Bestimmung der Überlappungszeit ($\Delta T$) aus der Differenz der Zeitpunkte der ersten und zweiten Signatur (13a, 14a; 13b, 14b) aufweist.

**12.** Messsystem (7) nach einem der Ansprüche 8-11, **dadurch gekennzeichnet, dass**

a) der gesamte Einspeisestrom ($I_0$) gleich der Summe des ersten und zweiten Stroms ($I_1+I_2$) ist und/oder
b) die Messstromquelle (11) einen konstanten Gleichstrom ($I_0$) in der Grössenordnung weniger Ampere liefert und insbesondere ein Akkumulator mit einem vorgeschalteten Widerstand ist.

**13.** Messsystem (7) nach einem der Ansprüche 8-12, **dadurch gekennzeichnet, dass** während einer Messphase vor Trennung der Abbrandkontakte (5)

a) über dem Schaltgerät (1) ein Schalterwiderstand ($R_2$) und über den Paralleleiter (12) zum Schaltgerät (1) ein Parallelleiterwiderstand ($R_1$) vorhanden ist und
b) ein Verhältnis des Parallellleiterwiderstands ($R_1$) zum Schalterwiderstand ($R_2$) kleiner als 100, bevorzugt kleiner als 30, besonders bevorzugt kleiner als 10, insbesondere kleiner als 5, ist und
c) insbesondere dass der Parallelleiterwiderstand ($R_1$) kleiner als 10 mΩ, bevorzugt kleiner als 2 mΩ, besonders bevorzugt kleiner als 1 mΩ, insbesondere gleich einem Maximum des Schalterwiderstands ($R_2$), ist.

**14.** Messsystem (7) nach einem der Ansprüche 8-12, **dadurch gekennzeichnet, dass**

a) das Messsystem (7) Mittel zur Erfassung der Kontaktbewegung (s(t)) umfasst und/oder
b) das Messsystem (7) ein tragbares Gerät (7) ist und/oder
c) das Schaltgerät (1) ein Leistungsschalter (1), ein Hochstromschalter (1) oder ein Lasttrennschalter (1) ist.

**Fig. 1**

$R_2 [t]$

$I_2$

$I_0$

$I_1$

$R_1$

8,8a

9

7

10

11

12

**Fig. 2**

Fig. 3

Fig. 4

EP 1 793 235 A1

**Europäisches Patentamt**

**EUROPÄISCHER RECHERCHENBERICHT**

Nummer der Anmeldung

EP 05 40 5679

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | GROTH R ET AL: "DIAGNOSE AN HOCHSPANNUNGS-LEISTUNGSSCHALTERN" ELEKTROTECHNISCHE ZEITSCHRIFT - ETZ, VDE VERLAG GMBH, BERLIN, DE, Bd. 114, Nr. 19, 1. Oktober 1993 (1993-10-01), Seiten 1214-1216,1218, XP000403004 ISSN: 0948-7387 * Abbildungen 1,2 * * Seite 1214 - Seite 1216, linke Spalte * ----- | 1-14 | INV. G01R31/327 |
| X | STOKES A D ET AL ELECTROCHEMICAL SOCIETY: "CIRCUIT-BREAKER DIAGNOSTICS" ULSI SCIENCE AND TECHNOLOGY 1987. PHILADELPHIA, MAY 11 - 15, 1987, PROCEEDINGS OF THE INTERNATIONAL SYMPOSIUM ON ULTRA LARGE SCALE INTEGRATION SCIENCE AND TECHNOLOGY, PENNINGTON, ELECTROCHEMICAL SOCIETY, US, Bd. SYMP. 1, 28. August 1988 (1988-08-28), Seiten 1-8, XP000042544 * Abbildungen 1,2 * * Seite 1, rechte Spalte * * Seite 2, rechte Spalte - Seite 3, linke Spalte, Absatz 1 * ----- | 1-14 | |
| X | DE 198 53 511 A1 (RWE ENERGIE AG; RWE NET AKTIENGESELLSCHAFT) 8. Juni 2000 (2000-06-08) * Abbildungen 1,2a-2c * * Spalte 2, Zeile 7 - Zeile 43 * * Spalte 4, Zeile 8 - Zeile 53 * * Ansprüche 2,3 * ----- -/-- | 1,8 | RECHERCHIERTE SACHGEBIETE (IPC) G01R H02B H02H H01H |

Der vorliegende Recherchenbericht wurde für alle Patentansprüche erstellt

| Recherchenort | Abschlußdatum der Recherche | Prüfer |
|---|---|---|
| Berlin | 28. April 2006 | Höller, H |

EPO FORM 1503 03.82 (P04C03)

Europäisches
Patentamt

**EUROPÄISCHER RECHERCHENBERICHT**

Nummer der Anmeldung

EP 05 40 5679

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | EP 1 555 683 A (ABB TECHNOLOGY AG) 20. Juli 2005 (2005-07-20) * Abbildungen 1,3,4 * * Absätze [0003], [0018], [0019] * * Absatz [0047] - Absatz [0054] * * Ansprüche 12,13 * ----- | 1,2,8 | |
| A | PATENT ABSTRACTS OF JAPAN Bd. 007, Nr. 160 (P-210), 14. Juli 1983 (1983-07-14) -& JP 58 070170 A (TOKYO SHIBAURA DENKI KK), 26. April 1983 (1983-04-26) * Zusammenfassung * * Abbildungen 1-3 * ----- | 1,8 | |
| A | US 6 528 960 B1 (RODEN GAREY GEORGE ET AL) 4. März 2003 (2003-03-04) * Abbildung 2b * * Zusammenfassung * * Spalte 1, Zeile 51 - Spalte 2, Zeile 16 * ----- | 1,8 | RECHERCHIERTE SACHGEBIETE (IPC) |
| A | US 4 492 919 A (MILKOVIC ET AL) 8. Januar 1985 (1985-01-08) * Abbildungen 1-2a * * Spalte 1, Zeile 10 - Zeile 15 * ----- | 1,8 | |
| A | US 5 107 204 A (BULLOCK ET AL) 21. April 1992 (1992-04-21) * Abbildungen 1,2 * * Spalte 4, Zeile 50 - Zeile 65 * ----- | 1,8 | |
| A | DE 36 14 206 A1 (BBC AKTIENGESELLSCHAFT BROWN,BOVERI & CIE) 24. September 1987 (1987-09-24) * Abbildungen 1,2 * * Spalte 4, Zeile 25 - Zeile 27 * ----- | 4,5,9,10 | |

-/--

Der vorliegende Recherchenbericht wurde für alle Patentansprüche erstellt

| Recherchenort | Abschlußdatum der Recherche | Prüfer |
|---|---|---|
| Berlin | 28. April 2006 | Höller, H |

EPO FORM 1503 03.82 (P04C03)

**Europäisches Patentamt**

**EUROPÄISCHER RECHERCHENBERICHT**

Nummer der Anmeldung

EP 05 40 5679

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | TORRES H ET AL: "DESIGN, CONSTRUCTION AND CALIBRATION OF THREE DEVICES TO MEASURE DIRECTLY LIGHTNING PARAMETERS" HIGH VOLTAGE ENGINEERING, 1999. ELEVENTH INTERNATIONAL SYMPOSIUM ON (CONF. PUBL. NO. 467) LONDON, UK 23-27 AUG. 1999, LONDON, UK,IEE, UK, 23. August 1999 (1999-08-23), Seiten 1-4, XP001152461 ISBN: 0-85296-719-5 * das ganze Dokument * ----- | 4,5,9,10 | |
| | | | **RECHERCHIERTE SACHGEBIETE (IPC)** |

Der vorliegende Recherchenbericht wurde für alle Patentansprüche erstellt

| Recherchenort | Abschlußdatum der Recherche | Prüfer |
|---|---|---|
| Berlin | 28. April 2006 | Höller, H |

EPO FORM 1503 03.82 (P04C03)

# EP 1 793 235 A1

## ANHANG ZUM EUROPÄISCHEN RECHERCHENBERICHT
## ÜBER DIE EUROPÄISCHE PATENTANMELDUNG NR.

EP 05 40 5679

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

28-04-2006

| Im Recherchenbericht angeführtes Patentdokument | Datum der Veröffentlichung | Mitglied(er) der Patentfamilie | Datum der Veröffentlichung |
|---|---|---|---|
| DE 19853511 A1 | 08-06-2000 | KEINE | |
| EP 1555683 A | 20-07-2005 | CN 1645534 A<br>DE 102004002173 A1 | 27-07-2005<br>04-08-2005 |
| JP 58070170 A | 26-04-1983 | KEINE | |
| US 6528960 B1 | 04-03-2003 | KEINE | |
| US 4492919 A | 08-01-1985 | KEINE | |
| US 5107204 A | 21-04-1992 | AU 598073 B2<br>AU 8217287 A<br>BR 8706968 A<br>CH 674678 A5<br>ES 2008394 A6<br>FR 2608773 A1<br>GB 2199149 A | 14-06-1990<br>23-06-1988<br>26-07-1988<br>29-06-1990<br>16-07-1989<br>24-06-1988<br>29-06-1988 |
| DE 3614206 A1 | 24-09-1987 | EP 0237776 A2<br>US 4742197 A | 23-09-1987<br>03-05-1988 |

EPO FORM P0461

Für nähere Einzelheiten zu diesem Anhang : siehe Amtsblatt des Europäischen Patentamts, Nr.12/82